# EUROPÄISCHE PATENTSCHRIFT

(11) **EP 0 790 331 B1**
(45) Veröffentlichungstag und Bekanntmachung des Hinweises auf die Patenterteilung: **22.12.1999**
(21) Anmeldenummer: 97101695.1
(22) Anmeldetag: 04.02.1997
(51) Int. Cl.: C23C 14/50, C23C 14/56

(54) **Vorrichtung zum Greifen und Halten von Substraten**
Apparatus for gripping and holding of substrates
Dispositif de maintien et de préhension de substrats

(30) Priorität: 15.02.1996 DE 19605598
(43) Veröffentlichungstag der Anmeldung: 20.08.1997
(73) Patentinhaber: Singulus Technologies AG, 63755 Alzenau (DE)
(72) Erfinder: Kempf, Stefan, 63755 Alzenau-Albstadt (DE); Reising, Michael, 63776 Mömbris (DE)
(74) Vertreter: Heunemann, Dieter, Dr.

(56) Entgegenhaltungen:
- DE-U- 9 307 263

## Beschreibung

**Die Erfindung bezieht sich auf** eine Vorrichtung zum Greifen und Halten von Substraten mit einem oder mehreren in einer Vakuumkammer angeordneten Substrathaltern und einem oder mehreren verstellbar angeordneten Greifern, die gegen die Wirkung eines Stelldrucks bzw. gegen die Wirkung einer Feder in eine erste Stellung und über die Wirkung einer einem pneumatischen Druck Pₐ aussetzbaren Membrane und/oder eines mit dieser zusammenwirkenden Stellteils in eine zweite Stellung verstellbar sind, wobei in der einen Stellung das Substrat gehalten und in der zweiten Stellung das Substrat für den Weitertransport gelöst wird.

**Es ist bereits eine Vorrichtung** zum Greifen und Halten eines scheibenförmigen Substrats bekannt (DE-U-93 07 263). Diese Vorrichtung besteht aus zahlreichen kreisförmig angeordneten Greifern und einer elastisch ausgebildeten Membrane, die in einem eine Öffnung aufweisenden, druckfesten Gehäuse angeordnet ist. Auf der Vorder- und Rückseite der Membrane können unterschiedliche Drücke eingestellt sein, und die Membrane kann so angeordnet sein, daß bei einem Differenzdruck eine Auslenkung der Membrane aus der Ruhelage erfolgt und bei Druckausgleich die Membrane über eine Druckfeder wieder in ihre Ruhelage zurückkehrt.

Der Differenzdruck an der Membrane wird dadurch erzeugt, daß auf der einen Seite der Membrane ein glockenförmiges Gehäuse angeordnet ist, das mit einer zentralen Bohrung versehen ist. Zwischen dem Ende der Bohrung des glockenförmigen Gehäuses und der Oberfläche der Membrane wird ein Druckraum gebildet. Die in dem glockenförmigen Gehäuse vorgesehene Bohrung ist über eine pneumatische Leitung mit einer externen Pumpe versehen, die lediglich die Aufgabe hat, an der Oberfläche der Membrane einen Differenzdruck mit Bezug auf den in der darunterliegenden Kammer vorgesehenen Vakuumdruck herzustellen, so daß durch Druckbeaufschlagung der Membrane und ein an die Membrane anschließendes Stellteil der Greiferarm aus seiner das Substrat haltenden Stellung in eine weitere Stellung verstellbar ist, in der der oder die Greifer das Substrat freigeben. Eine derartige Vorrichtung ist aufwendig und teuer, da zur Erzeugung dieses Differenzdrucks eine besondere Pumpe erforderlich ist und die Membrane gegenüber dem Druck in der Vakuumkammer abgedichtet werden muß, um somit den notwendigen Druck an der Rückseite der Membrane erzeugen zu können. Außerdem ist eine derartige Anordnung sehr störanfällig, da die zusätzlich erforderliche Pumpe völlig abgekoppelt von den anderen Pumpen zur Erzeugung des Vakuumdrucks in der Vakuumkammer arbeitet, so daß keine ganz exakte Abstimmung auf den Arbeitsprozeß zum Verstellen der Membrane und der Abnahme des Substrats möglich ist. Insgesamt arbeitet eine derartige Vorrichtung relativ langsam, da die Freigabe des Substrats erst erfolgen kann, wenn der notwendige Systemdruck hinter der Membrane über die Fremdpumpe aufgebaut ist. Die Druckluftzuleitung muß flexibel zum Haltemechanismus angeordnet sein.

**Der Erfindung liegt die Aufgabe zugrunde**, den zwischen Atmosphären- und Vakuumdruck auftretenden Differenzdruck als Steuerdruck zum Verstellen der Substratgreifer einzusetzen.

**Die Erfindung löst die Probleme dadurch**, daß die Membrane zwischen Vakuumkammer und Einschleuskammer vorgesehen ist. Durch die vorteilhafte Ausbildung und Anordnung der Membrane kann auf eine zusätzliche Pumpe zum Verstellen der Membrane verzichtet werden, da bei der erfindungsgemäßen Vorrichtung der Differenzdruck zwischen dem Druck in der Vakuumkammer und dem Druck der gefluteten Kammer zum Verstellen der Membrane und damit zum Verstellen der Greifer eingesetzt werden kann. Hierdurch wird automatisch sichergestellt, daß sofort bei Einleitung der Flutung der oberhalb des Substrats liegenden Kammer die Membrane anspricht, einen Stellweg zurücklegt und damit die Greifer automatisch, also in Abhängigkeit der Durchflutung, freigibt. Diese Anlage arbeitet dadurch störungsfrei, sehr präzise und auch wesentlich schneller als die bekannten Anlagen. Da der Differenzdruck zwischen Atmosphärendruck und dem Druck in der Vakuumkammer als Stellgröße zum Verstellen der Membrane eingesetzt wird, kann, wie bereits dargelegt, auf eine zusätzliche Pumpe, Steuerventile und die die Membrane zur Vakuumkammer abdichtenden Teile mit der notwendigen Durchdringung verzichtet werden, so daß insgesamt eine sehr kostengünstige Vorrichtung zum Halten und Lösen der Substrate geschaffen wird. Durch den Verzicht zusätzlicher Pumpaggregate arbeitet die erfindungsgemäße Vorrichtung wesentlich zuverlässiger und erreicht insgesamt eine wesentlich höhere Standzeit als die bekannten Vorrichtungen. Durch den vorteilhaften Einsatz des Differenzdrucks in Verbindung mit der erfindungsgemäßen Anordnung der Membrane entfällt also eine Außensteuerung der einzelnen Greifer. Die Störanfälligkeit wird auch dadurch herabgesetzt, daß erst durch Fluten der Kammer ein zwangsweises Verstellen der Greifer erfolgt. Da diese von dem erfindungsgemäßen Differenzdruck abhängig sind und nicht von einem außenliegenden System, läßt sich in Millisekunden ein Lösen der Greifer erreichen.

Ferner ist es vorteilhaft, daß die einem in etwa konstanten Vakuumdruck Pᵥ auf einer Seite ausgesetzte Membrane über einen Differenzdruck P_{d} = Pₐ - Pᵥ steuerbar ist, der dann auftritt, wenn die Kammer zur Aufnahme des Substrats geflutet wird.

Eine zusätzliche Möglichkeit ist gemäß einer Weiterbildung der erfindungsgemäßen Vorrichtung, daß die Membrane über den Atmosphären- und/oder Vakuumdruck bzw. den Differenzdruck P_{d}, der sich aus dem Atmosphärendruck Pₐ in der Einschleuskammer abzüglich des Vakuumdrucks Pᵥ in der Vakuumkammer ergibt, steuerbar ist. Durch die vorteilhafte Anordnung der Membrane, die in die Vakuumkammer hineinragt, kann erstmalig auf einfache Weise der in der Kammer auftretende Vakuumdruck als Stellgröße zum Verstellen der Membrane eingesetzt werden.

In weiterer Ausgestaltung der Erfindung ist es vorteilhaft, daß die in der Vakuumkammer angeordnete Membrane aus einem flexiblen und nicht flexiblen Teil bzw. einem Metallteil bzw. Teller gebildet ist. Durch Verwendung eines flexiblen und eines nicht flexiblen Teils zur Bildung der Membrane wird eine exakte Führung des Stellteils zum Verstellen bzw. Verschwenken der Greifer geschaffen.

Gemäß einer bevorzugten Ausführungsform der erfindungsgemäßen Lösung ist schließlich vorgesehen, daß der nicht flexible Teil mit dem flexiblen Teil der Membrane fest verbunden ist und daß der nicht flexible Teil als kreisrunder Teller ausgebildet ist, der eine Öffnung der Membrane abdeckt.

Vorteilhaft ist es ferner, daß der flexible Teil der Membrane mit seinem äußeren Rand an einen Flansch der Vorrichtung und mit dem innenliegenden Rand an den Rand der im Teller vorgesehenen Öffnung fest angeschlossen ist und daß die Membrane und der Teller die einem ständigen Vakuumdruck Pᵥ ausgesetzte Kammer gegenüber der einem Atmosphärendruck Pₐ aussetzbaren Kammer bzw. Einschleuskammer abdichten.

Außerdem ist es vorteilhaft, daß der äußere Rand der Membrane in mindestens einer zwischen dem Flansch und dem Außenteil des Substrathalters vorgesehenen Nut einklemmbar und sicherbar ist und daß der Teller über einen koaxialen Zapfen mit einem zylinderförmigen Teil verbunden bzw. verschraubt ist, der auf einem mit einem ebenfalls koaxial angeordneten Flansch verbundenen Zapfen geführt ist. Durch die Verwendung einer Nut zur Aufnahme des äußeren Randes der Membrane erhält man eine sehr einfache Befestigungsart für die Membrane, die außerdem eine hohe Dichtigkeit gegenüber der gefluteten Kammer und der Vakuumkammer aufweist. Da der Teller über einen koaxialen Zapfen mit dem zylinderförmigen Teil verbunden bzw. verschraubt ist, kann bei Beschädigung der Membrane diese ohne weiteres gelöst werden. Hierzu braucht lediglich der Teller abgeschraubt und die Klemmverbindung der Membrane gelöst zu werden. Danach lassen sich diese Teile ohne weiteres ersetzen.

Ferner ist es vorteilhaft, daß das zylinderförmige Teil mit dem Stellteil fest verbunden ist und daß das Stellteil im Bereich seines einen Endes gegen einen oder mehrere Greifer anliegt.

Eine zusätzliche Möglichkeit ist gemäß einer Weiterbildung der erfindungsgemäßen Vorrichtung, daß das zylinderförmige Teil mit seinem einen oder zweiten Ende bzw. seinem Teller gegen einen feststehenden Flansch und mit seinem ersten oder anderen Ende bzw. Stellteil gegen den Greifer bzw. Hebelarm des Greifers anlegbar ist und daß sich bei auftretendem Differenzdruck P_{d} die Membrane weiter in den Vakuumraum bewegt und dabei den oder die Greifer vom Bohrungsrand des Substrats wegbewegt und diese freigibt.

In weiterer Ausgestaltung der Erfindung ist es vorteilhaft, daß der feststehende Flansch mit dem Flansch der Vorrichtung mittel- oder unmittelbar fest verbunden ist und eine zylinderförmige Verlängerung aufweist, in der die Feder aufgenommen ist. Durch die Verwendung einer zylinderförmigen Verlängerung auf dem feststehenden Flansch wird eine gute Führung der Feder gewährleistet und gleichzeitig sichergestellt, daß bei Druckausgleich zwischen den beiden Kammern ein sofortiges Verstellen der Greifer erfolgt.

Von Vorteil ist es ferner, daß zwischen dem Flansch der Vorrichtung und dem feststehenden Flansch ein Tragteil zur verschwenkbaren Aufnahme der Greifer vorgesehen ist und daß der feststehende Flansch und das Tragteil über die gleichen Verbindungselemente mit dem Flansch der Vorrichtung lösbar verbunden sind. Da das Tragteil zur Aufnahme der Greifer zwischen den beiden Flanschen angeordnet ist, erhält man eine sehr gute, einfache Fixierung der Halterung.

Eine wesentlich vorteilhafte Ausführungsform erreicht man dadurch, daß die oberhalb der Membrane liegende Kammer bzw. die Einschleuskammer über eine erste Vakuumpumpe evakuiert und über eine weitere Einrichtung geflutet und die unterhalb der Membrane liegende Kammer über eine zweite Vakuumpumpe evakuiert wird, wobei die beiden Vakuumpumpen bzw. die zugehörigen Ventile derart steuerbar sind, daß der Differenzdruck P_{d} auf annähernd Null herabsenkbar ist, und daß die obere Kammer, die über eine Einrichtung bzw. über ein Steuerventil geflutet wird, dadurch zwangsweise das sofortige Verstellen der Greifer einleitet und daß die Membrane derart in die Vakuumkammer integriert ist, daß sie in einer Arbeitsstellung auf der einen Seite dem Atmosphärendruck Pₐ und auf der anderen Seite dem Vakuumdruck Pᵥ und in einer zweiten Stellung auf beiden Seiten dem Vakuumdruck Pᵥ ausgesetzt ist.

**Weitere Vorteile und Einzelheiten der Erfindung sind in den Patentansprüchen** und in der Beschreibung erläutert und in den Figuren dargestellt, wobei bemerkt wird, daß alle Einzelmerkmale und alle Kombinationen von Einzelmerkmalen erfindungswesentlich sind. Es zeigt:
- Figur 1: eine schematische Darstellung des Funktionsablaufs der Gesamtvorrichtung einer Sputteranlage,
- Figur 2: eine perspektivische Darstellung einer Vorrichtung zum Beschichten von Compact-Disks,
- Figur 3: eine Vorrichtung zum Greifen und Halten eines flachen, vorzugsweise scheibenförmigen Substrats.

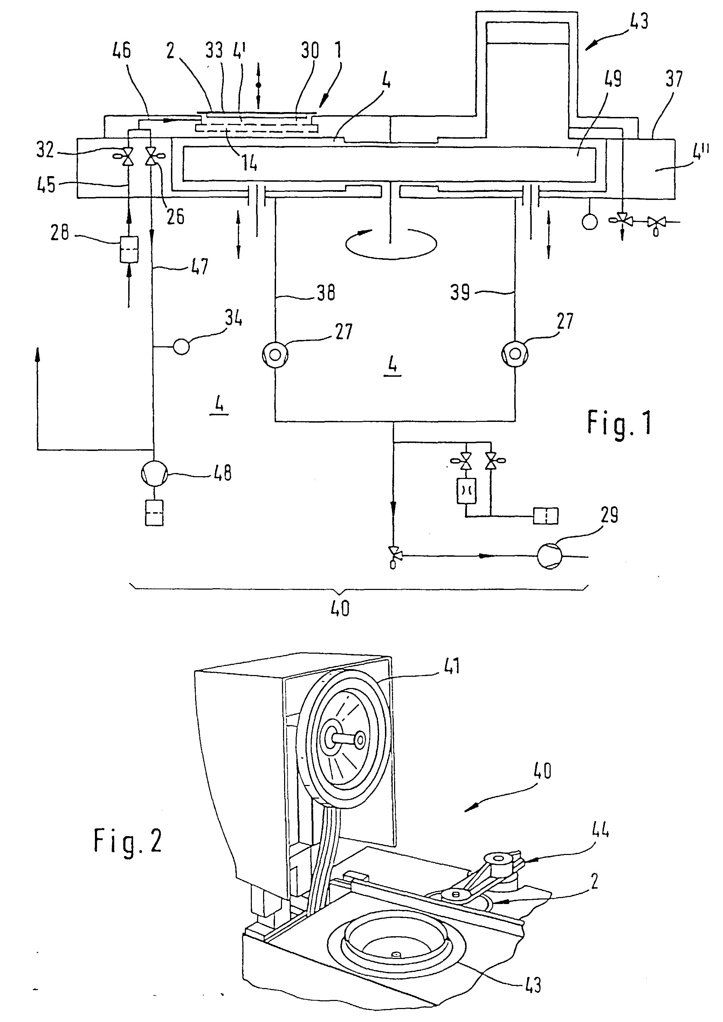

In der Zeichnung ist in Figur 2 eine perspektivische Darstellung eines oberen Teils einer Sputteranlage 40 wiedergegeben, zu dem ein um 180° drehbar gelagerter Greiferarm 44 gehört, mittels dessen die in Figur 2 mit 2 bezeichneten Substrate bzw. Compact Disks (CD) einer Vorrichtung 1 zum Greifen von Substraten (Disk-Receiver) zugeführt werden. Über diese Vorrichtung 1 gelangen die Substrate zu einer Prozeßstation 43, zu der auch eine in Figur 2 in einer geöffneten Stellung wiedergegebene Kathode 41 gehört.

In Figur 1 ist das Funktionsschema der Sputteranlage 40 mit den wesentlichen Vorrichtungsteilen wiedergegeben.

Das Substrat 2 wird mittels des Greiferarms 44 und eines zugehörigen Tellers 33, zu dem ebenfalls eine in Figur 1 nicht dargestellte Greifvorrichtung gehört, einer weiteren Vorrichtung zum Greifen von Substraten aufgegeben. In Figur 1 befindet sich der Teller 33 oberhalb eines Tellers bzw. Substrataufnahmeteils 14. In der Stellung gemäß Figur 1 sind die beiden Teller 33 und 14 koaxial zueinander ausgerichtet, so daß das Substrat 2 von dem Teller 33 dem Substrataufnahmeteil 14 aufgegeben werden kann.

In der Stellung gemäß Figur 1 ist der Teller 14 nach oben gefahren und dichtet ein ringförmiges Volumen bzw. eine Einschleuskammer 30 ab. Die Einschleuskammer 30 befindet sich zwischen dem oberen Teller 33 und dem unteren Teller bzw. Substrataufnahmeteil 14. Die am Teller 33 vorgesehenen, in Fig. 1 nicht dargestellten Greifelemente halten die Compact Disk oberhalb des Substrataufnahmeteils 14.

Die Einschleuskammer 30 kann über einen Filter 28 geflutet werden, der hierzu über eine Leitung 45 mit einem Ventil 32 verbunden ist, das über eine weitere Leitung 46 an die Einschleuskammer 30 angeschlossen ist. Durch Öffnen des Ventils 32 wird die Einschleuskammer 30 geflutet. Nachdem die Einschleuskammer 30 geflutet ist, wird der obere Teller angehoben, so daß das Substrat 2 ausgetauscht werden kann. Mittels des Greiferarms 44 kann die fertig beschichtete Compact Disk einer weiteren nicht dargestellten Transporteinrichtung zugeführt werden. Gleichzeitig wird eine neue zu bearbeitende Compact Disk 2 in die Einschleuskammer 30 eingelegt. Durch Absenken des Deckels 33 preßt sich ein in der Zeichnung nicht dargestellter O-Ring gegen die Oberfläche eines Gehäuses 37 der Einschleuskammer 30 an, die dadurch vakuumdicht verschlossen wird. Der in der Einschleuskammer 30 herrschende Atmosphärendruck wird durch Schließen eines Ventils 32 und durch anschließendes Öffnen des Ventils 26, das über die Leitung 46 mit der Einschleuskammer 30 verbunden ist, evakuiert. Eine Vakuumpumpe 48 pumpt die in der Einschleuskammer 30 vorhandene Luft ab und erzeugt den erforderlichen Vakuumdruck.

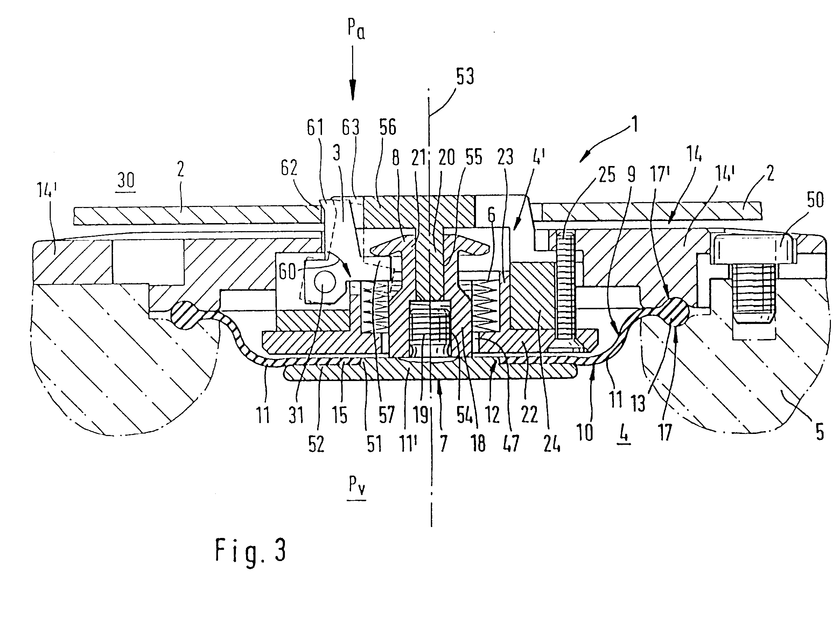

Bei diesem Vorgang öffnen sich nachstehend näher erläuterte Greifer 3, die in Figur 3 im Detail wiedergegeben sind. Die Greifer 3 erfassen das Substrat 2 bzw. die Compact Disk. Dies tritt sofort ein, wenn der Druck in der Einschleuskammer 30 in etwa dem Druck in einer Vakuumkammer 4 (Figur 3) entspricht, d. h. wenn Druckausgleich erfolgt ist. Ist die Einschleuskammer 30 soweit evakuiert, daß der erforderliche Meßdruck, der mittels einer Meßzelle 34 ermittelt wird, hergestellt ist, so kann die Vorrichtung 1 nach unten abgesenkt und das auf einem Drehteller 49 (Figur 1) abgelegte Substrat 2 mittels des Drehtellers 49 der Prozeßstation 43 schrittweise zugeführt werden. Hierzu dreht sich der Drehteller 49 jeweils um 120° weiter. Anschließend wird das Substrataufnahmeteil 14 angehoben, wobei sich ein nicht dargestellter O-Ring gegen die Unterseite des Deckels der Kathode 41 legt.

Nach diesem Arbeitsschritt kann die Einschleuskammer 30 wieder über das Ventil 32 geflutet werden. Bei diesem Flutungsvorgang entsteht eine Druckdifferenz P_{d}, die sich aus dem Atmosphärendruck Pₐ in der Einschleuskammer 30 und dem Vakuumdruck Pᵥ in der Vakuumkammer 4 (siehe Figur 3) ergibt (P_{d} = Pₐ - Pᵥ).

Durch diese Druckdifferenz werden die Greifer 3 wieder verschwenkt und das Substrat 2 freigegeben. Bei diesem Arbeitsvorgang wird gleichzeitig auch der Greifer des Substrataufnahmeteils bzw. des Tellers 33 aktiviert, so daß das Substrat von dem Teller 33 übernommen werden kann. Dieser Arbeitsprozeß wiederholt sich fortlaufend.

Die Vakuumkammer 4 wird über die Leitungen 38, 39 und die Vorpumpe 29 evakuiert.

In Figur 3 ist die Vorrichtung 1 zum Greifen und Halten der Substrate 2 im Detail wiedergegeben, wobei die Vorrichtung 1 lediglich schematisch angedeutet ist.

Die Vorrichtung 1 besteht aus einem Flansch 14', der über Schraubenbolzen 50 mit einem Substrathalter 5 lösbar verbunden ist. Zwischen dem Flansch 14' und dem Substrathalter 5 ist eine halbkreisförmige Nut 17 vorgesehen, in der ein wulstartiger Rand 13 einer Membrane 7 eingeklemmt ist. Die Membrane 7 befindet sich in der Vakuumkammer 4 und besteht aus einem flexiblen Teil 11 und einem an diesen angeschlossenen, nicht flexiblen Teil 11', der als kreisrunder Teller ausgebildet ist und der in einer Öffnung 12 der Membrane 7 eingelassen ist. Hierzu weist der Teller 11' einen zylinderförmigen Ansatz 51 auf, so daß ein Randteil 52 gebildet wird, an das der flexible Teil 11 der Membrane 7 befestigt bzw. anvulkanisiert sein kann. Die Membrane 7 dichtet den oberen Teil einer Vakuumkammer 4' (Figur 3) bzw. 4'' (Figur 1) gegenüber der einem permanenten Vakuumdruck Pᵥ ausgesetzten Vakuumkammer 4 ab. Der flexible Teil 11 der Membrane 7 ist mit seinem äußeren Rand 13 an den Flansch 14' und mit seinem innenliegenden Rand 15 an den zylinderförmigen Ansatz 51 angeschlossen. Der äußere Rand 13 ist in der Nut 17, 17' des Flansches 14' und dem Substrathalter 5 eingeklemmt.

Die Vakuumkammern 4', 4'' werden dann einem Atmosphärendruck Pₐ ausgesetzt, wenn, wie bereits erwähnt, das Ventil 32 geöffnet und die Einschleuskammer 30 geflutet wird.

Der Teller 11' der Membrane 7 weist einen Zapfen 19 auf, der koaxial zu einer Mittelachse 53 der Vorrichtung 1 ausgerichtet ist. Der Zapfen 19 ist fest bzw. einteilig mit dem Teller 11' verbunden. Der Zapfen 19 weist Außengewinde 54 auf und kann daher mit einem zylinderförmigen Teil 18 verbunden bzw. lösbar verschraubt werden.

Das zylinderförmige Teil 18 ist hierzu ebenfalls koaxial zum Flansch 14' ausgerichtet und weist in seinem oberen Bereich eine zylinderförmige Bohrung 55 auf, in die sich ein Zapfen 20 erstreckt. Der Zapfen 20 ist mit einem zylinderförmigen Ansatz 56 verbunden, der über Verbindungselemente 25 mit dem Flansch 14' verbunden ist. Auf den zylinderförmigen Ansatz 56 kann die Compact Disk bzw. das Substrat 2 aufgeschoben und mittels der drei oder mehreren Greifer 3 gehalten werden. Der zylinderförmige Teil 18 ist bei auftretender Druckdifferenz P_{d} mit Bezug auf die Mittelachse 53 auf dem Zapfen 20 vertikal verstellbar.

Am oberen Ende des zylinderförmigen Teils 18 ist ein Stellteil bzw. ein glockenförmig ausgebildeter Flansch 8 vorgesehen. Das Stellteil 8 ist an einem oberen Ende 21 des zylinderförmigen Teils 18 fest angeschlossen.

Wie aus Figur 3 hervorgeht, liegt der Flansch 8 mit seinem äußeren Ende gegen einen Hebelarm 57 je eines Greifers 3 an. Der Greifer 3 ist auf einem mit Bezug auf Figur 3 horizontal verlaufenden Bolzen 31 zwischen der in ausgezogenen Linien dargestellten Stellung (Haltestellung) und einer in gestrichelten Linien dargestellten Stellung (Freigabestellung) verschwenkbar gelagert.

Das untere Ende des zylinderförmigen Teils 18 bewegt sich mit seinem einen Ende bzw. seinem Teller 11' in Richtung der Unterseite eines feststehenden Flansches 22, während er mit seinem anderen Ende bzw. seinem Stellteil 8 gegen den Greifer 3 bzw. dessen Hebelarm 57 anliegt. In diesem Betriebszustand befindet sich der Greifer 3 in der in Figur 3 dargestellten Halteposition, in der das Substrat 2 von den Greifern 3 getragen wird. Der Flansch 22 ist über die Verbindungselemente 25 mit einem Tragteil 24 und dem Flansch 14' fest verbunden. Auf dem Flansch 22 befindet sich eine zylinderförmige Verlängerung 23, in der eine Feder bzw. Tellerfeder 6 aufgenommen ist. Die Feder 6 stützt sich mit ihrem unteren Ende gegen den Flansch 22 und mit ihrem oberen Ende gegen den Hebelarm 57 des Greifers 3 ab und drückt diesen bei Druckausgleich Pₐ = Pᵥ in seine Halteposition gemäß Figur 3. Hierzu umgibt die zylinderförmige Feder 6 das zylinderförmige Teil 18. Das mit dem Flansch 22 verbundene Tragteil 24 dient zur verschwenkbaren Aufnahme der Greifer 3. Der Flansch 22 weist eine Bohrung 47 auf, durch die sich das zylinderförmige Teil 18 erstreckt.

Der feststehende Flansch 22 und der Tragteil 24 sind über die gleichen Verbindungselemente 25 mit dem Flansch 14' der Vorrichtung 1 lösbar verbunden. Die oberhalb der Membrane 7 vorgesehene Vakuumkammer 4', 4" bzw. die Einschleuskammer 30 kann, wie bereits mit Bezug auf Figur 1 erläutert, über das Ventil 32 geflutet und über die Pumpe 48 evakuiert werden. Die unterhalb der Membrane 7 vorgesehene Vakuumkammer 4 wird bei Arbeitseinsatz nicht geflutet und über eine Vakuumpumpen 27 bzw. die Vorpumpe evakuiert bzw. auf einem bestimmten Druckniveau gehalten.

Wird für den Arbeitsprozeß und zum Transport des Substrats 2 die Einschleuskammer 30 bzw. Vakuumkammer 4' über das Ventil 32 gemäß Figur 1 geflutet, so tritt oberhalb der Membrane 7 ein sofortiger Druckanstieg Pₐ ein, so daß die Membrane 7 aufgrund der Druckdifferenz (P_{d} = Pₐ - Pᵥ) weiter in die Vakuumkammer 4 gemäß Figur 3 nach unten bewegt wird und mittels des Stellteils 8 der Greifer 3 aus der in ausgezogenen Linien dargestellten Stellung in die in gestrichelten Linien dargestellte Stellung (Freigabestellung für Substrat) im Uhrzeigerdrehsinn gemäß Pfeil 60 verschwenkt wird. Dabei gelangt der obere Teil 61 des Greifers 3 aus dem Bereich eines Randes 62 einer Bohrung 63 des Substrats 2 und gibt auf diese Weise das Substrat bzw. die Compact Disk zum Transport frei.

Mit der erfindungsgemäßen Anlage wird also immer dann ein zwangsweises Verstellen des Greifers 3 in eine Freigabestellung gemäß Figur 3 bewirkt, wenn die Einschleuskammer 30 geflutet wird.

Wird nach der Substratübergabe die Einschleuskammer 30 bzw. Vakuumkammer 4' über die Pumpe 48 wieder evakuiert, so erfolgt zwischen der Einschleuskammer 30 und der Vakuumkammer 4 ein Druckausgleich, so daß dadurch die Feder 6 den Hebelarm 57 und dadurch auch das Stellteil 8 nach oben bewegt, da nun auf einer Seite 9 und einer anderen Seite 10 der Membrane 7 die gleichen Druckzustände herrschen. Hierdurch arbeitet das Greifersystem völlig störungsfrei und kann in kürzester Zeit, also in Millisekunden, ansprechen.

Durch die sehr kurze Ansprechzeit der Greifer 3 und das zwangsweise Verstellen beim Fluten der Einschleuskammer 30 wird die Standsicherheit bzw. der Arbeitsprozeß störungsfreier und die Taktzeit zusätzlich verringert. Außerdem kann durch diese Anordnung die Vorrichtung 1 zum Greifen der Substrate wesentlich einfacher gestaltet und somit kostengünstiger hergestellt werden, da man insgesamt mit weniger Bauteilen auskommen kann. Die bisherige externe Ansteuerung der Membrane zum Verstellen der Greifer 3 war aufgrund der fehlenden Einzelteile störanfälliger und nicht so funktionssicher, wenn z. B. die externe Versorgungspumpe zur Erzeugung eines Überdrucks an der Membrane 7 ausfiel. Die Oberseite der Membrane 7 ist über die Bohrung 47 mit der Vakuumkammer 4' verbunden.

### Bezugszeichenliste

- 1: Vorrichtung zum Greifen von Substraten (Disk-Receiver); Teller
- 2: Substrat, CD
- 3: Greifer
- 4: Vakuumkammer
- 4': Vakuumkammer, dem Atmosphärendruck aussetzbar
- 4'': Vakuumkammer
- 5: Substrathalter
- 6: Feder, Tellerfeder
- 7: Membrane
- 8: Stellteil, Flansch
- 9: erste Seite
- 10: zweite Seite
- 11: flexibles Teil
- 11': nicht flexibles Teil bzw. Metallteil, Teller
- 12: Öffnung
- 13: Rand
- 14: Substrataufnahmeteil (Teller)
- 14': Flansch
- 15: Rand
- 17: Nut
- 17': Nut
- 18: zylinderförmiges Teil
- 19: Zapfen
- 20: Zapfen
- 21: Ende, Stellteil
- 22: feststehender Flansch
- 23: Verlängerung
- 24: Tragteil
- 25: Verbindungselement
- 26: Einrichtung, Steuerventil (offen, wenn geflutet wird)
- 27: Vakuumpumpe (Turbo-Molekularpumpe)
- 28: Filter
- 29: Vorpumpe
- 30: Einschleuskammer = Vakuumkammer
- 31: Bolzen
- 32: Ventil
- 33: Teller zur Aufnahme von CD
- 33': Teller, Deckel
- 34: Meßzelle
- 37: Gehäuse mit Vakuumkammer
- 38: Vakuumleitung
- 39: Vakuumleitung
- 40: Sputteranlage
- 41: Kathode
- 43: Prozeßstation
- 44: Greiferarm
- 45: Leitung
- 46: Leitung
- 47: Bohrung
- 47': Leitung
- 48: Vakuumpumpe
- 49: Drehteller
- 50: Schraubenbolzen
- 51: zylinderförmiger Ansatz
- 52: Randteil
- 53: Mittelachse
- 54: Außengewinde
- 55: Bohrung
- 56: zylindrischer Ansatz
- 57: Hebelarm
- 60: Pfeil
- 61: oberer Teil des Greifers
- 62: Rand
- 63: Bohrung, Substrat 2

## Patentansprüche

1. Vorrichtung (1) zum Greifen und Halten von Substraten (2) mit einem oder mehreren in einer Vakuumkammer (4, 4', 4'') angeordneten Substrathaltern (5) und einem oder mehreren verstellbar angeordneten Greifern (3), die gegen die Wirkung eines Stelldrucks bzw. gegen die Wirkung einer Feder (6) in eine erste Stellung und über die Wirkung einer einem pneumatischen Druck Pₐ aussetzbaren Membrane (7) und/oder eines mit dieser zusammenwirkenden Stellteils (8) in eine zweite Stellung verstellbar sind, wobei in der einen Stellung das Substrat (2) gehalten und in der zweiten Stellung das Substrat (2) für den Weitertransport gelöst wird, **dadurch gekennzeichnet**, daß die Membrane (7) zwischen Vakuumkammer (4) und Einschleuskammer (30) vorgesehen ist.

2. Vorrichtung nach Anspruch 1, **dadurch gekennzeichnet**, daß die einem in etwa konstanten Vakuumdruck Pᵥ auf einer Seite (10) ausgesetzte Membrane (7) über einen Differenzdruck P_{d} = Pₐ - Pᵥ steuerbar ist, der dann auftritt, wenn die Kammer (30, 4', 4'') zur Aufnahme des Substrats (2) geflutet wird.

3. Vorrichtung nach Anspruch 1 oder 2, **dadurch gekennzeichnet**, daß die Membrane (7) über den Atmosphären- und/oder Vakuumdruck bzw. den Differenzdruck P_{d}, der sich aus dem Atmosphärendruck Pₐ in der Einschleuskammer (30) abzüglich des Vakuumdrucks Pᵥ in der Vakuumkammer (4) ergibt, steuerbar ist.

4. Vorrichtung nach Anspruch 1, **dadurch gekennzeichnet**, daß die in der Vakuumkammer (4) angeordnete Membrane (7) aus einem flexiblen (11) und nicht flexiblen Teil (11') bzw. einem Metallteil bzw. Teller gebildet ist.

5. Vorrichtung nach einem oder mehreren der vorhergehenden Ansprüche, **dadurch gekennzeichnet**, daß der nicht flexible Teil (11') mit dem flexiblen Teil (11) der Membrane (7) fest verbunden ist.

6. Vorrichtung nach Anspruch 1, **dadurch gekennzeichnet**, daß der nicht flexible Teil (11') als kreisrunder Teller ausgebildet ist, der eine Öffnung (12) der Membrane (7) abdeckt.

7. Vorrichtung nach einem oder mehreren der vorhergehenden Ansprüche, **dadurch gekennzeichnet**, daß der flexible Teil (11) der Membrane (7) mit seinem äußeren Rand (13) an einen Flansch (14) der Vorrichtung (1) und mit dem innenliegenden Rand (15) an den Rand (51) der im Teller (11') vorgesehenen Öffnung (12) fest angeschlossen ist.

8. Vorrichtung nach einem oder mehreren der vorhergehenden Ansprüche, **dadurch gekennzeichnet**, daß die Membrane (7) und der Teller (11') die einem ständigen Vakuumdruck Pᵥ ausgesetzte Kammer (4) gegenüber der einem Atmosphärendruck Pₐ aussetzbaren Kammer (4') bzw. Einschleuskammer (30) abdichten.

9. Vorrichtung nach einem oder mehreren der vorhergehenden Ansprüche, **dadurch gekennzeichnet**, daß der äußere Rand (13) der Membrane (7) in mindestens einer zwischen dem Flansch (14') und dem Außenteil des Substrathalters (5) vorgesehenen Nut (17, 17') einklemmbar und sicherbar ist.

10. Vorrichtung nach einem oder mehreren der vorhergehenden Ansprüche, **dadurch gekennzeichnet**, daß der Teller (11) über einen koaxialen Zapfen (19) mit einem zylinderförmigen Teil (18) verbunden bzw. verschraubt ist, der auf einem mit einem ebenfalls koaxial angeordneten Flansch (14) verbundenen Zapfen (20) geführt ist.

11. Vorrichtung nach einem oder mehreren der vorhergehenden Ansprüche, **dadurch gekennzeichnet**, daß das zylinderförmige Teil (18) mit dem Stellteil (8) fest verbunden ist.

12. Vorrichtung nach einem oder mehreren der vorhergehenden Ansprüche, **dadurch gekennzeichnet**, daß das Stellteil (8) im Bereich seines einen Endes (21) gegen einen oder mehrere Greifer (3) anliegt.

13. Vorrichtung nach einem oder mehreren der vorhergehenden Ansprüche, **dadurch gekennzeichnet**, daß das zylinderförmige Teil (18) mit seinem einen oder zweiten Ende bzw. seinem Teller (11') gegen einen feststehenden Flansch (22) und mit seinem ersten oder anderen Ende bzw. Stellteil (8) gegen den Greifer (3) bzw. Hebelarm (57) des Greifers (3) anlegbar ist.

14. Vorrichtung nach einem oder mehreren der vorhergehenden Ansprüche, **dadurch gekennzeichnet**, daß sich bei auftretendem Differenzdruck P_{d} die Membrane (7) weiter in den Vakuumraum (4) bewegt und dabei den oder die Greifer (3) vom Bohrungsrand (62) des Substrats (2) wegbewegt und dieses freigibt.

15. Vorrichtung nach einem oder mehreren der vorhergehenden Ansprüche, **dadurch gekennzeichnet**, daß der feststehende Flansch (22) mit dem Flansch (14) der Vorrichtung (1) mittel- oder unmittelbar fest verbunden ist.

16. Vorrichtung nach einem oder mehreren der vorhergehenden Ansprüche, **dadurch gekennzeichnet**, daß der feststehende Flansch (22) eine zylinderförmige Verlängerung (23) aufweist, in der die Feder (6) aufgenommen ist.

17. Vorrichtung nach einem oder mehreren der vorhergehenden Ansprüche, **dadurch gekennzeichnet**, daß zwischen dem Flansch (14) der Vorrichtung (1) und dem feststehenden Flansch (22) ein Tragteil (24) zur verschwenkbaren Aufnahme der Greifer (3) vorgesehen ist.

18. Vorrichtung nach einem oder mehreren der vorhergehenden Ansprüche, **dadurch gekennzeichnet**, daß der feststehende Flansch (22) und das Tragteil (24) über die gleichen Verbindungselemente (25) mit dem Flansch (14') der Vorrichtung (1) lösbar verbunden sind.

19. Vorrichtung nach einem oder mehreren der vorhergehenden Ansprüche, **dadurch gekennzeichnet**, daß die oberhalb der Membrane (7) liegende Kammer (4') bzw. die Einschleuskammer (30) über eine erste Vakuumpumpe (48) evakuiert und über eine weitere Einrichtung (32) geflutet und die unterhalb der Membrane (7) liegende Kammer (4) über eine zweite Vakuumpumpe (27) evakuiert wird, wobei die beiden Vakuumpumpen (48, 27) bzw. die zugehörigen Ventile derart steuerbar sind, daß der Differenzdruck P_{d} auf annähernd Null herabsenkbar ist.

20. Vorrichtung nach einem oder mehreren der vorhergehenden Ansprüche, **dadurch gekennzeichnet**, daß die obere Kammer (4'), die über eine Einrichtung bzw. über ein Steuerventil (32) geflutet wird, dadurch zwangsweise das sofortige Verstellen der Greifer (3) einleitet.

21. Vorrichtung nach einem oder mehreren der vorhergehenden Ansprüche, **dadurch gekennzeichnet**, daß der Greifer (3) über ein Zugteilverstellbar ist, das dann anspricht, wenn der Stelldruck dem Atmosphärendruck Pₐ entspricht.

22. Vorrichtung nach einem oder mehreren der vorhergehenden Ansprüche, **dadurch gekennzeichnet**, daß sich die Greifer (3) auf der Seite befinden, auf der sich ein Druck einstellt, der höher ist als der Vakuumdruck Pᵥ.

23. Vorrichtung nach Anspruch 1, **dadurch gekennzeichnet**, daß die Membrane (7) derart in die Vakuumkammer (4) integriert ist, daß sie in einer Arbeitsstellung auf der einen Seite (9) dem Atmosphärendruck Pₐ und auf der anderen Seite (10) dem Vakuumdruck Pᵥ und in einer zweiten Stellung auf beiden Seiten dem Vakuumdruck Pᵥ ausgesetzt ist.

## Claims

1. A device (1) for gripping and holding substrates (2), said device comprising one or more substrate holders (5) arranged within a vacuum chamber (4, 4', 4'') and one or more displaceably arranged grippers (3) which are displaceable into a first position counter to the action of an adjusting pressure or counter to the action of a spring (6) and into a second position in response to the action of a diaphragm (7) that is exposable to a pneumatic pressure Pₐ and/or an adjusting part (8) cooperating with said diaphragm, said substrate (2) being held in said first position and released in said second position for being further transported, **characterized in that** said diaphragm (7) is interposed between the vacuum chamber (4) and the lock chamber (30).

2. The device according to claim 1, **characterized in that** said diaphragm (7) which is exposed on one side (10) to an approximately constant vacuum pressure Pᵥ is controllable via a differential pressure P_{d} = Pₐ - Pᵥ which occurs when the chamber (30, 4', 4'') is flooded for receiving said substrate (2).

3. The device according to claim 1 or 2, **characterized in that** said diaphragm (7) is controllable by the atmospheric and/or vacuum pressure or the differential pressure P_{d} which is the result of the atmospheric pressure Pₐ in said lock chamber (30) minus the vacuum pressure Pᵥ in said vacuum chamber (4).

4. The device according to claim 1, **characterized in that** said diaphragm (7) within said vacuum chamber (4) is formed of a flexible part (11) and an inflexible part (11') or a metal part or a plate.

5. The device according to one or more of the preceding claims, **characterized in that** said inflexible part (11') is firmly joined to said flexible part (11) of said diaphragm (7).

6. The device according to claim 1, **characterized in that** said inflexible part (11') is a circular plate which covers an opening (12) of said diaphragm (7).

7. The device according to one or more of the preceding claims, **characterized in that** said flexible part (11) of said diaphragm (7) is connected by its outer edge (13) to a flange (14) of said device (1) and by its inner edge (15) to the edge (51) of said opening (12) provided in said plate (11').

8. The device according to one or more of the preceding claims, **characterized in that** said diaphragm (7) and said plate (11') seal off said chamber (4), which is exposed to a constant vacuum pressure Pᵥ, from said chamber (4') or lock chamber (30), which may be exposed to an atmospheric pressure Pₐ.

9. The device according to one or more of the preceding claims, **characterized in that** said outer edge (13) of said diaphragm (7) may be clamped or secured in at least one groove (17, 17') provided between said flange (14') and the outer edge of said substrate holder (5).

10. The device according to one or more of the preceding claims, **characterized in that** said plate (11) is joined or screwed via a coaxial protrusion (19) to a cylindrical part (18) that is guided on a protrusion (20) joined to a likewise coaxially arranged flange (14).

11. The device according to one or more of the preceding claim, **characterized in that** said cylindrical part (18) is firmly joined to said adjusting part (8).

12. The device according to one or more of the preceding claims, **characterized in that** said adjusting part (8) rests against one or more grippers (3) in the region of its one end (21).

13. The device according to one or more of the preceding claims, **characterized in that** said cylindrical part, with its one or second end or its plate (11'), may be placed against a fixed flange (22) and with its first or other end or adjusting part (8) against said gripper (3) or a lever arm (57) of said gripper (3).

14. The device according to one or more of the preceding claims, **characterized in that** in case of differential pressure P_{d} said diaphragm (7) moves farther into said vacuum chamber (4) and in the process moves the gripper(s) (3) away from the bore edge (62) of said substrate (2) and releases it.

15. The device according to one or more of the preceding claims, **characterized in that** said fixed flange (22) is directly or indirectly firmly joined to said flange (14) of said device (1).

16. The device according to one or more of the preceding claims, **characterized in that** said fixed flange (22) has a cylindrical extension (23) in which said spring (6) is received.

17. The device according to one or more of the preceding claims, **characterized in that** a support part (24) for the pivotable reception of said grippers (3) is provided between said flange (14) of said device (1) and said fixed flange (22).

18. The device according to one or more of the preceding claims, **characterized in that** said fixed flange (22) and said support part (24) are releasably joined to said flange (14') of said device (1) via the same connecting elements (25).

19. The device according to one or more of the preceding claims, **characterized in that** said chamber (4') or said lock chamber (30) located above said diaphragm (7) is evacuated via a first vacuum pump (48) and flooded via a further means (32) and the chamber (4) located below said diaphragm (7) is evacuated via a second vacuum pump (27), said two vacuum pumps (48, 27) or the associated valves being controllable in such a way that the differential pressure P_{d} can be lowered to nearly zero.

20. The device according to one or more of the preceding claims, **characterized in that** said upper chamber (4'), which is flooded via means or a control valve (32), thereby necessarily initiates an immediate displacement of the grippers (3).

21. The device according to one or more of the preceding claims, **characterized in that** said gripper (3) is adjustable via a tension member which comes into action whenever the adjusting pressure corresponds to the atmospheric pressure Pₐ.

22. The device according to one or more of the preceding claims, **characterized in that** the grippers (3) are on the side at which a pressure higher than the vacuum pressure Pᵥ prevails.

23. The device according to claim 1, **characterized in that** said diaphragm (7) is integrated into said vacuum chamber (4) in such a way that, in one operating position, it is exposed to the atmospheric pressure Pₐ on the one side (9) and to the vacuum pressure Pᵥ on the other side (10) and, in a second position, it is exposed to the vacuum pressure Pᵥ on both sides.

## Revendications

1. Dispositif (1) pour saisir et maintenir des substrats (2) avec un ou plusieurs porte-substrats (5) disposés dans une chambre à vide (4, 4', 4") et un ou plusieurs préhenseurs (3) disposés de façon réglable, susceptibles d'être déplacés de façon réglée à l'encontre de l'effet d'une pression de réglage ou à l'encontre de l'effet d'un ressort (6), dans une première position et, par l'intermédiaire de l'effet d'une membrane (7) susceptible d'être exposée à une pression pneumatique Pₐ et/ou d'une partie de réglage (8) coopérant avec celle-ci, dans une deuxième position, dans la première position le substrat (2) étant maintenu et dans la deuxième position le substrat (2) étant relâché pour la continuation du transport, caractérisé en ce que la membrane (7) est prévue entre la chambre à vide (4) et une chambre d'introduction (30).

2. Dispositif selon la revendication 1, caractérisé en ce que la membrane (7) exposée sur une face (10) à une dépression Pᵥ à peu près constante est susceptible d'être commandée par le biais d'une pression différentielle P_{d} = Pₐ - Pᵥ qui se produit lorsque la chambre (30, 4', 4") destinée à recevoir le substrat (2) est remplie.

3. Dispositif selon la revendication 1 ou 2, caractérisé en ce que la membrane (7) est susceptible d'être commandée par l'intermédiaire de la pression atmosphérique et/ou de la dépression ou de la pression différentielle P_{d} résultant de la pression atmosphérique Pₐ dans la chambre d'introduction (30), moins la dépression Pᵥ régnant dans la chambre à vide (4).

4. Dispositif selon la revendication 1, caractérisé en ce que la membrane (7) disposée dans la chambre à vide (4) est constituée d'une partie flexible (11) et d'une partie non flexible (11') ou d'une partie métallique ou d'un plateau.

5. Dispositif selon l'une ou plusieurs des revendications précédentes, caractérisé en ce que la partie non flexible (11') est reliée rigidement à la partie flexible (11) de la membrane (7).

6. Dispositif selon la revendication 1, caractérisé en ce que la partie non flexible (11') est réalisée sous la forme de plateaux ronds circulaires, recouvrant une ouverture (12) de la membrane (7).

7. Dispositif selon l'une ou plusieurs des revendications précédentes, caractérisé en ce que la partie flexible (11) de la membrane (7) est raccordée rigidement, par son bord extérieur (13), à une bride (14) du dispositif (1) et, par le bord intérieur (15), au bord (51) de l'ouverture (12) prévue dans le plateau (11').

8. Dispositif selon l'une ou plusieurs des revendications précédentes, caractérisé en ce que la membrane (7) et le plateau (11') isolent de façon étanche la chambre (4) exposée à une dépression Pᵥ permanente, par rapport à la chambre (4') ou la chambre d'introduction (30) susceptible d'être exposée à une pression atmosphérique Pa.

9. Dispositif selon l'une ou plusieurs des revendications précédentes, caractérisé en ce que le bord extérieur (13) de la membrane (7) est susceptible d'être enserré et retenu dans au moins une gorge (17, 17') prévue entre la bride (14') et la partie extérieure du porte-substrat (5).

10. Dispositif selon l'un ou plusieurs des revendications précédentes, caractérisé en ce que le plateau (11) est relié ou vissé, par l'intermédiaire d'un téton coaxial (19), à une partie (18) de forme cylindrique qui est guidée sur une téton (20), relié à une bride (14) disposée également coaxialement.

11. Dispositif selon l'une ou plusieurs des revendications précédentes, caractérisé en ce que la partie (18) à forme cylindrique est reliée rigidement à la partie de réglage (8).

12. Dispositif selon l'une ou plusieurs des revendications précédentes, caractérisé en ce que la partie de réglage (8) appuie dans la zone d'une de ses extrémités (21) contre un ou plusieurs préhenseurs (3).

13. Dispositif selon l'une ou plusieurs des revendications précédentes, caractérisé en ce que la partie (18) à forme cylindrique est susceptible d'être appliquée, par son extrémité ou deuxième extrémité ou son plateau (11'), contre une bride (22) stationnaire et par sa première ou son autre extrémité ou la partie de réglage (8) contre le préhenseur (3) ou le bras de levier (57) du préhenseur (3).

14. Dispositif selon l'une ou plusieurs des revendications précédentes, caractérisé en ce que, lorsque la pression différentielle P_{d} se manifeste, la membrane (7) se déplace plus à l'intérieur de l'enceinte à vide (4) et écarte alors le ou les préhenseurs (3) du bord de perçage (62) du substrat (2) et libère celui-ci.

15. Dispositif selon l'une ou plusieurs des revendications précédentes, caractérisé en ce que la bride (22) stationnaire est reliée rigidement indirectement ou directement à la bride (14) du dispositif (1).

16. Dispositif selon l'une ou plusieurs des revendications précédentes, caractérisé en ce que la bride stationnaire (22) présente un prolongement (23) en forme de cylindre dans lequel est logé le ressort (6).

17. Dispositif selon l'une ou plusieurs des revendications précédentes, caractérisé en ce qu'entre la bride (14) du dispositif (1) et la bride (22) stationnaire est prévue une partie porteuse (24) destinée à loger avec faculté de pivotement les préhenseurs (23).

18. Dispositif selon l'une ou plusieurs des revendications précédentes, caractérisé en ce que la bride stationnaire (22) et la partie porteuse (24) sont reliées de façon désolidarisable à la bride (14') du dispositif (1), par l'intermédiaire des mêmes éléments de liaison (25).

19. Dispositif selon l'une ou plusieurs des revendications précédentes, caractérisé en ce que la chambre (4') située au-dessus de la membrane (7) ou la chambre d'introduction (30) est évacuée par l'intermédiaire d'une première pompe à vide (48) et remplie par l'intermédiaire d'un autre dispositif (32) et la chambre (4) située au-dessous de la membrane (7) est évacuée par l'intermédiaire d'une deuxième pompe à vide (27), les deux pompes à vide (48, 27) ou les soupapes afférentes étant susceptibles d'être commandées de manière que la pression différentielle P_{d} puisse être abaissée à une valeur à peu près égale à zéro.

20. Dispositif selon l'une ou plusieurs des revendications précédentes, caractérisé en ce que la chambre supérieure (4'), qui est remplie par un dispositif ou par l'intermédiaire d'une soupape de commande (32), induit de ce fait obligatoirement le déplacement de réglage immédiat des préhenseurs (3).

21. Dispositif selon l'une ou plusieurs des revendications précédentes, caractérisé en ce que le préhenseur (3) est réglable par l'intermédiaire d'un élément de traction réagissant lorsque la pression de réglage correspond à la pression atmosphérique Pₐ.

22. Dispositif selon l'une ou plusieurs des revendications précédentes, caractérisé en ce que les préhenseurs (3) se trouvent sur un côté sur lequel est réglée une pression supérieure à la dépression Pᵥ.

23. Dispositif selon la revendication 1, caractérisé en ce que la membrane (7) est intégrée dans la chambre à vide (4) de manière que, dans une position de travail, elle soit exposée sur une face (9) à la pression atmosphérique Pₐ et que sur l'autre face (10) elle soit exposée à la dépression Pᵥ et que, dans une deuxième position, elle soit exposée sur les deux faces à la dépression Pᵥ.
